(19) Europäisches Patentamt / European Patent Office / Office européen des brevets

(11) **EP 3 726 239 A1**

(12) **EUROPEAN PATENT APPLICATION**

(43) Date of publication:
**21.10.2020 Bulletin 2020/43**

(51) Int Cl.:
**G01R 33/44** (2006.01)     **G01R 33/563** (2006.01)

(21) Application number: **19170364.4**

(22) Date of filing: **19.04.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Koninklijke Philips N.V.**
**5656 AG Eindhoven (NL)**

(72) Inventors:
• **MARIAPPAN, Yogesh Kannan**
**5656 AE Eindhoven (NL)**
• **NEELAVALLI, Jaladhar**
**5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **SUSCEPTIBILITY-WEIGHTING FROM PHASE-CONTRAST MR IMAGING**

(57)     The invention relates to a method of MR imaging of an object (10) placed in an examination volume of a MR apparatus (1). It is an object of the invention to enable more efficient combined phase contrast and susceptibility weighted MR imaging. The method of the invention comprises the following steps:
- generation of MR signals by subjecting the object (10) to an imaging sequence comprising motion- or flow-encoding switched magnetic field gradients;
- phase-sensitive acquisition of the MR signals; and
- reconstruction of at least one MR image from the acquired MR signals, wherein a motion- or flow-contrast is derived from the motion- or flow-induced phase information and wherein a susceptibility-weighting is derived from the motion- or flow independent phase information comprised in the acquired MR signals. Moreover, the invention relates to an MR apparatus for carrying out this method as well as to a computer program to be run on an MR apparatus.

Fig. 2

**Description**

FIELD OF THE INVENTION

The invention relates to the field of magnetic resonance (MR) imaging. It concerns a method of MR imaging of an object. The invention also relates to a MR apparatus and to a computer program to be run on a MR apparatus.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation, and are usually not invasive.

According to the MR method in general, the body of the patient to be examined is arranged in a strong, uniform magnetic field ($B_0$ field) whose direction at the same time defines an axis (normally the z-axis) of the co-ordinate system on which the measurement is based. The magnetic field produces different energy levels for the individual nuclear magnetic spins in dependence on the magnetic field strength which can be excited (magnetic resonance) by application of an alternating electromagnetic field (RF field, also referred to as $B_1$ field) of defined frequency (Larmor frequency, or MR frequency). From a macroscopic point of view the distribution of the individual nuclear magnetic spins produces an overall magnetization which can be deflected out of the state of equilibrium by application of an electromagnetic pulse of appropriate frequency (RF pulse) while the magnetic field extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied RF pulse. In case of a flip angle of 90°, the nuclear magnetic spins are deflected from the z-axis to the transverse plane.

After termination of the RF pulse, the magnetization relaxes back to the original state of equilibrium, in which the magnetization in the z direction is built up again with a first time constant $T_1$ (spin-lattice or longitudinal relaxation time), and the magnetization in the direction perpendicular to the z direction relaxes with a second time constant $T_2$ (spin-spin or transverse relaxation time). The variation of the magnetization can be detected by means of one or more receiving RF coils which are arranged and oriented within an examination volume of the MR device in such a manner that the variation of the magnetization is measured in the direction perpendicular to the z-axis. The decay of the transverse magnetization is accompanied, after application of, for example, an RF pulse with a flip angle of 90°, by a transition of the nuclear magnetic spins (induced by local magnetic field inhomogeneity) from an ordered state with the same phase to a state in which all phase angles are uniformly distributed (dephasing). The dephasing can be compensated by means of a refocusing RF pulse (for example an RF pulse with a flip angle of 180°). This produces an echo signal (spin echo) in the receiving coils.

In order to realize spatial resolution in the body of the patient, linear magnetic field gradients extending along the three main axes are superposed on the uniform magnetic field, leading to a linear spatial dependency of the nuclear magnetic spins' resonance frequency. The signal picked up in the receiving coils then contains components of different frequencies which can be associated with different locations in the body of the patient. The MR signal received via the RF coils corresponds to the spatial frequency domain, which is called k-space. The data is usually collected in k-space along multiple lines acquired with different phase encoding. Each line is digitized by collecting a number of samples. A set of k-space data is converted to a MR image by means of Fourier transformation or other appropriate reconstruction algorithms.

In the so-called phase contrast angiography (PCA) method, bipolar flow-encoding gradients are used in a three-dimensional or two dimensional MR imaging procedure to provide a non-invasive measure of in vivo blood flow. PCA provides good suppression of signals arising from stationary tissue, thereby permitting the visualization of small vessels having relatively slow flow. The imaging sequence consists of an RF excitation pulse, a bipolar flow-encoding magnetic field gradient pulse, and conventional gradient pulse waveforms for the generation of gradient refocused MR signals. The flow-encoding magnetic field gradient pulses are applied in the time period between the RF excitation and the beginning of the image formation magnetic field gradient pulses to encode the velocity of the flowing spins in the phase information of the detected MR signals. These bipolar flow-encoding magnetic field gradients are modulated during the imaging procedure to discriminate between signals arising from flowing material (blood) and signals arising from stationary tissue (see C. L. Dumoulin, S. P. Souza, M. F. Walker, and W. Wagle, "Three-dimensional phase contrast angiography", Magn. Reson. Med., vol. 9, no. 1, pp. 139-149, Jan. 1989.).

Magnetic resonance elastography (MRE) is a known MR imaging technique that measures the mechanical properties (elastic shear modulus, "stiffness") of soft tissues by introducing shear waves and imaging their propagation. Diseased tissues are often stiffer than the surrounding normal tissue. MRE works by using an additional motion-encoding magnetic field gradient waveform in the imaging sequence to sensitize the MR imaging scan to shear waves in the imaged tissue. The shear waves are generated by an electro-mechanical transducer on the surface of the skin. Both the mechanical excitation and the motion sensitizing magnetic field gradient are at the same frequency. This encodes the amplitude of the shear wave in the tissue in the local phase of the MR image. An appropriate algorithm can be used to extract a quantitative measure of tissue stiffness from the MR image in an elastogram (see R. Muthupillai, D. J. Lomas, P. J. Rossman, J. F. Greenleaf, A. Manduca, and R. L. Ehman, "Magnetic resonance elastography by direct visualization of propagating acoustic strain waves", Science, vol. 269, no. 5232, pp. 1854-1857, Sep. 1995).

Susceptibility weighted imaging (SWI), is an MR imaging technique that is particularly sensitive to venous blood, hemorrhage and iron storage. SWI typically uses a long echo time, gradient-recalled echo pulse sequence to acquire MR signal data. The SWI method exploits the susceptibility differences between tissues and uses the phase information in the MR signal data image to detect these differences. The values in the obtained phase image are constrained from $-\pi$ to $\pi$ so if the value goes above $\pi$ it wraps to $-\pi$, inhomogeneities in the magnetic field cause low frequency background gradients. This causes the phase values to slowly vary across the image which creates phase wrapping and obscures the image. This type of artefact can be removed by phase unwrapping and/or by high pass filtering the original complex data to remove the low frequency variations in the phase image. The magnitude and phase data are finally combined to produce an enhanced contrast magnitude image (see E. M. Haacke, Y. Xu, Y.-C. N. Cheng, and J. R. Reichenbach, "Susceptibility weighted imaging (SWI)", Magn. Reson. Med. Off. J. Int. Soc. Magn. Reson. Med., vol. 52, no. 3, pp. 612-618, 2004).

The three afore-mentioned MR imaging techniques are used commonly. They provide independent yet complementary contrasts useful for different clinical diagnosis processes. Currently, dedicated MR scans are required to obtain each of the complementary contrast images. This increases the total time the patient needs to be in the scanner. Multiple independent scans also lead to the requirement of (error prone) registration of the images obtained from the different scans due to inter-scan differences, for example caused by patient motion.

## SUMMARY OF THE INVENTION

From the foregoing it is readily appreciated that there is a need for an improved MR imaging technique. It is consequently an object of the invention to enable more efficient combined phase contrast and susceptibility weighted MR imaging.

In accordance with the invention, a method of MR imaging of an object placed in an examination volume of a MR apparatus is disclosed. The method comprises the steps of:

- generation of MR signals by subjecting the object to an imaging sequence comprising motion- or flow-encoding switched magnetic field gradients;
- phase-sensitive acquisition of the MR signals;
- reconstruction of at least one MR image from the acquired MR signals, wherein a motion- or flow-contrast is derived from the motion- or flow-induced phase information and wherein a susceptibility-weighting is derived from the motion-independent phase information comprised in the acquired MR signals.

The invention enables the derivation of a susceptibility-weighting from the MR signal data of any other MR imaging technique that involves a flow- or motion-induced phase contrast. The invention can be implemented as a mere post-processing technique and obviates the need for an additional scan to obtain an SWI contrast image. The invention thus reduces the total required scan time. Moreover, since the different contrasts are obtained from the same MR signal data, the resulting images are naturally co-registered. Thus, in cases where the different contrasts are used, the diagnosis becomes possible for the radiologist without an additional post-processing step for registering different, separately acquired MR images.

The present invention is applicable to multiple MR imaging techniques in which the information of interest is encoded into the phase of the MR image, which phase is extracted from the MR image and used for further analysis. In all such techniques, like in the above mentioned PCA and MRE technique, the background phase, i.e. the motion- or flow-independent phase is not used for further analysis. According to the invention, however, it is this background phase which is used to derive the SWI contrast.

The field of application of the present invention is in the diagnosis of diseases where the different contrasts are useful as they provide complementary information. For example, the assessment of liver fibrosis, cirrhosis, siderotic nodules etc. are potentially interesting applications. Similarly, as both MRE and SWI are used for the assessment brain function, the invention can be applicable advantageously for imaging of vasculature or shear stiffness in the brain while simultaneously the SWI contrast can provide information about calcifications and artherosclerotic plaque. Other examples are the imaging of arterio-venous malformations and of venous thrombosis where both PCA and SWI information are acquired for assessing the arterial and venous parts of the circulation.

In a preferred embodiment, the imaging sequence comprises pairs of motion- or flow-encoding magnetic field gradients having varying (opposed) polarities. In a commonly used embodiment of MRE, a two-point encoding is performed, where motion encoding gradients of opposite polarities and a gradient echo formation are used to obtain two MR images in which the same motion- or flow-induced displacement of nuclear spins is encoded into the phase of the respective image voxels with opposite signs (see N. J. Pelc, M. A. Bernstein, A. Shimakawa, and G. H. Glover, "Encoding strategies for three-direction phase-contrast MR imaging of flow", J. Magn. Reson. Imaging, vol. 1, no. 4, pp. 405-413, 1991). The phase values in each of the two images are not only determined by displacements caused by motion or flow but also by other factors like, in particular, main magnetic field heterogeneity and heterogeneity of tissues with different magnetic susceptibilities. The susceptibility weighting can thus be derived in a straight forward fashion from the MRE data obtained in the above-described way using pairs of motion- or flow-encoding magnetic field gradients having opposed polarities.

As in conventional SWI imaging, the reconstructed MR image can be weighted using a diamagnetic or a paramagnetic phase mask derived from the motion-independent phase information. The phase mask translates the obtained motion- or flow-independent phase value at each image location into a weighting factor depending on whether diamagnetic or paramagnetic structures are present in the imaged region. This phase mask can then be applied, e.g., to a magnitude image reconstructed from the acquired MR signals to generate the desired susceptibility contrast.

In a preferred embodiment of the invention, at least two MR images are reconstructed from the acquired MR signals, whereof a first MR image is a phase-contrast MR image, most notably a phase contrast angiogram or a magnetic resonance elastography phase image, and a second MR image is a susceptibility weighted image. Hence, two MR images of different contrasts including complementary diagnostic information are reconstructed from the MR signal data acquired in only a single scan.

The method of the invention described thus far can be carried out by means of a MR apparatus including at least one main magnet coil for generating a uniform static magnetic field within an examination volume, a number of gradient coils for generating switched magnetic field gradients in different spatial directions within the examination volume, at least one RF coil for generating RF pulses within the examination volume and/or for receiving MR signals from an object positioned in the examination volume, a control unit for controlling the temporal succession of RF pulses and switched magnetic field gradients, and a reconstruction unit. The method of the invention can be implemented, for example, by a corresponding programming of the reconstruction unit and/or the control unit of the MR apparatus.

The method of the invention can be advantageously carried out in most MR devices in clinical use at present. To this end it is merely necessary to utilize a computer program by which the MR apparatus is controlled such that it performs the above-explained method steps of the invention. The computer program may be present either on a data carrier or be present in a data network so as to be downloaded for installation in the control unit of the MR apparatus.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig. 1 shows a MR apparatus for carrying out the method of the invention;
Fig. 2 shows example MR images acquired from an Agar-Agar phantom with stone inclusions, the invention is applied in combination with MRE imaging;
Fig. 3 shows example brain MR images;
Fig. 4 shows example liver MR images;
Fig. 5 shows example images to illustrate the application of the invention in combination with PCA imaging.

DETAILED DESCRIPTION OF THE EMBODIMENTS

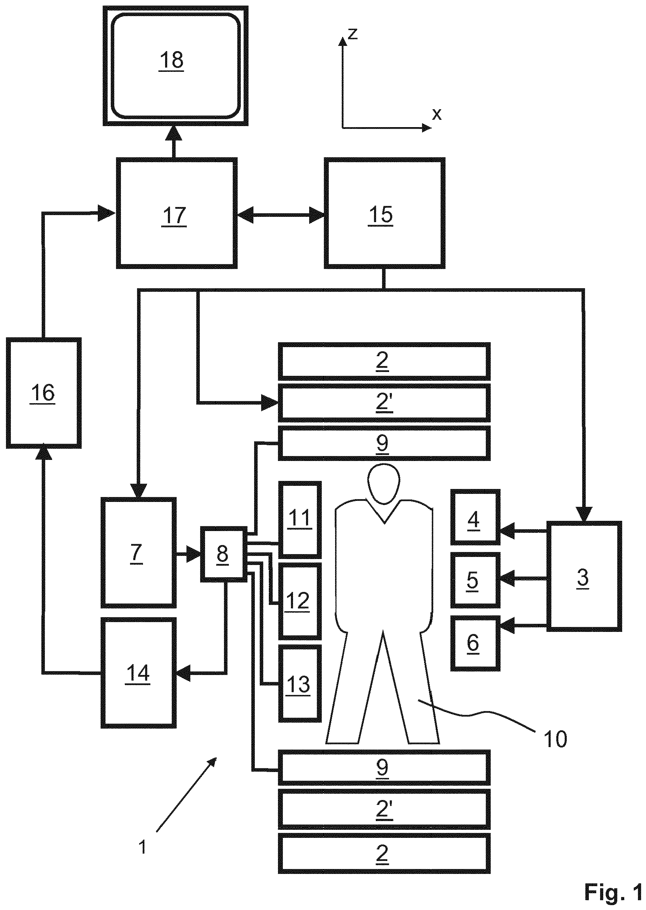

With reference to Fig. 1, a MR device 1 which can be used for carrying out the method of the invention is shown. The device comprises superconducting or resistive main magnet coils 2 such that a substantially uniform, temporally constant main magnetic field Bo is created along a z-axis through an examination volume. The device further comprises a set of (1st, 2nd, and - where applicable - 3rd order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to excite, invert or saturate nuclear magnetic spins, to induce, refocus, and manipulate magnetic resonance, to spatially and otherwise encode magnetic resonance, and the like to perform MR imaging.

More specifically, a gradient pulse amplifier 3 applies current pulses to selected ones of whole-body gradient coils 4, 5 and 6 along x, y and z-axes of the examination volume. A digital RF transmitter 7 transmits RF pulses, via a send/receive switch 8, to a body RF coil 9 to transmit RF pulses into the examination volume. A typical MR imaging sequence is composed of RF pulses of short duration which, taken together with any applied magnetic field gradients, achieve a selected manipulation of nuclear magnetic resonance, including the selection of a portion of a body 10 positioned in the examination volume. The MR signals are also picked up by the body RF coil 9.

For generation of MR images of a limited region of the body 10 by means of parallel imaging, a set of local array RF coils 11, 12, 13 is placed contiguous to the region to be imaged. The array coils 11, 12, 13 can be used to receive MR signals induced by RF transmissions with the body RF coil.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the current flow through the shimming coils 2' as well as the gradient pulse amplifier 3 and the RF transmitter 7 to generate an imaging sequence according to the invention. The receiver 14 receives the generated MR signals as k-space lines in rapid succession. A data acquisition system 16 performs analog-to-digital conversion of the received MR signal and convert it to a digital format suitable for further processing. In modern MR devices the data acquisition system 16 is a separate computer which is specialized in the acquisition of raw image data.

Ultimately, the digital raw image data is reconstructed into an image representation by a reconstruction processor 17 which applies an appropriate reconstruction algorithm. The MR image represents a three-dimensional volume. The image is then stored in an image memory where it may be accessed for converting projections or other portions of the image representation into an appropriate format for visualization, for example via a video monitor 18 which provides a human-readable display of the resultant MR image.

In an embodiment of the invention, a SWI contrast MR image is obtained from conventionally acquired MRE signal data. The imaging sequence used for acquiring the MRE signal data is a gradient echo sequence comprising motion-encoding magnetic field gradients of opposed polarities. Two MR images are initially reconstructed in which the same displacement (caused by the shear waves induced in the imaged tissue) is encoded into the phase of the MR images with opposite signs. At each image location, the phase is determined not only by the motion-induced displacement but also by motion-independent factors, such as magnetic field heterogeneity and heterogeneity of tissues with different magnetic susceptibility. This background phase is utilized according to the invention to derive a susceptibility weighting. The complex valued image values of the two MR images at a given location can be represented as $S_1$ and $S_2$:

$$S_1 = M_1 e^{i\theta_1}$$

$$S_2 = M_2 e^{i\theta_2}$$

Wherein $M_1$ and $M_2$ are the magnitudes of the signals, $\theta_1$ and $\theta_2$ are the corresponding phases. The motion-dependent phase contributions to the two signals are equal but of opposite sign due to the opposed polarities of the motion-encoding magnetic field gradients. Thus, $\theta_1 = \theta_m + \theta_b$ and $\theta_2 = -\theta_m + \theta_b$, wherein $\theta_m$ is the motion-induced phase and $\theta_b$ is the background phase determined by magnetic field heterogeneity and susceptibility effects. The typical processing in MRE involves complex conjugate multiplication of the two complex images and extraction of the purely motion-dependent phase:

$$S_{MRE} = \angle(S_1 * conj(S_2)) = \angle(M_1 M_2 e^{i(\theta_1 - \theta_2)}) = \angle(M_1 M_2 e^{i(2\theta_m)})$$

This motion dependent phase $\theta_m$ is then used in the subsequent post-processing steps to calculate the mechanical properties of the imaged tissues (see R. Muthupillai, D. J. Lomas, P. J. Rossman, J. F. Greenleaf, A. Manduca, and R. L. Ehman, "Magnetic resonance elastography by direct visualization of propagating acoustic strain waves", Science, vol. 269, no. 5232, pp. 1854-1857, Sep. 1995). It has to be noted that the background phase information $\theta_b$, while available in the acquired MR signal data, is not used in the conventional processing of MRE imaging.

The present invention exploits exactly this and uses the motion-independent background phase which incorporates very useful information especially since MRE is a gradient echo based pulse sequence with a relatively long echo time of about 20 ms, which emphasizes the susceptibility-induced image contrast. The background phase information can be derived from the MRE data as follows:

$$\angle S_{swip} = \angle(S_1 * S_2) = \angle(M_1 M_2 e^{i(\theta_1 + \theta_2)}) = \angle(M_1 M_2 e^{i(2\theta_b)})$$

$$\left|S_{swip}\right| = |S_1 * S_2| = \left|M_1 M_2 e^{i(\theta_1 + \theta_2)}\right| = \sqrt{M_1 M_2}$$

The background phase is $\theta_b = \angle S_{swip}/2$. $|S_{swip}|$ is an average magnitude image.

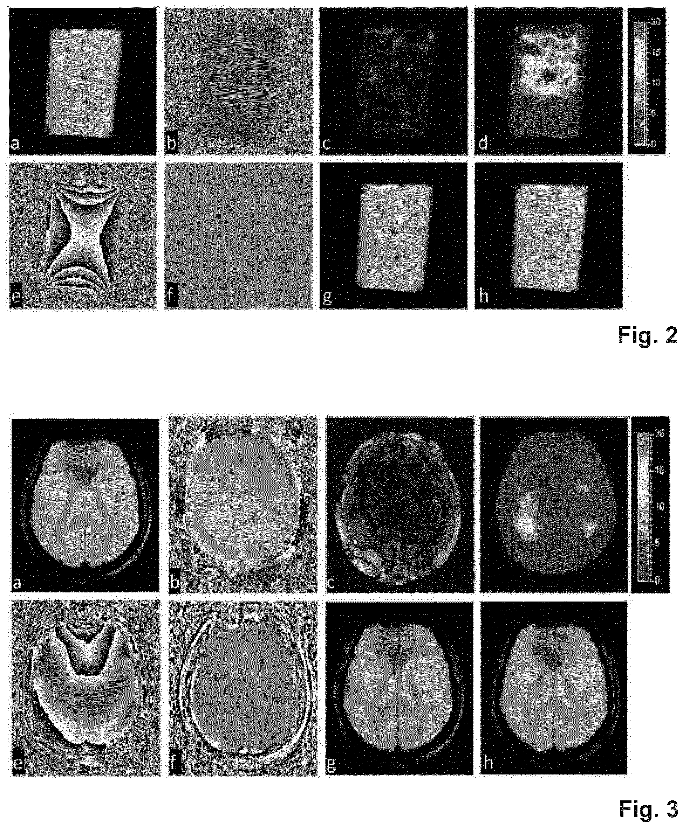

Fig. 2 shows example images acquired from an Agar-Agar phantom with stone inclusions. Fig. 2a shows the magnitude image $|S_{swip}|$, wherein the locations of the stone inclusions are indicated by arrows. Fig. 2b shows the MRE phase image $S_{MRE}$ derived from the acquired MR signal data using the above equations. The displacement image shown in Fig. 2c is calculated from the phase image $S_{MRE}$. The presence and the propagation of the shear waves can be easily seen. The shear wave-induced displacements of Fig. 2c are converted into a shear stiffness elastogram as shown in Fig. 2d. Fig. 2e shows the susceptibility-induced phase image $\angle S_{swip}$ computed using the above equations. A conventional (e.g. Laplacian-based) phase unwrapping algorithm and a spatial high pass filter are applied to $\angle S_{swip}$ to remove unwanted contributions to the background phase. The resulting phase image $\Phi_h(x,y)$ is shown in Fig. 2f. Mask functions based on the phase values of the tissues to be highlighted are defined for susceptibility weighting of the magnitude image $|S_{swip}|$ as follows:

$$mask_{dia}(x,y) = \begin{cases} \exp\left\{-\alpha(|\phi_h(x,y)| - \sigma\frac{\pi}{100})^\beta\right\} & |\phi_h(x,y)| > \sigma\frac{\pi}{100} \\ 1 & |\phi_h(x,y)| \le \sigma\frac{\pi}{100} \end{cases}$$

where $\alpha$ is 1.6 and $\beta$ is 1.2 and $\sigma$ is typically zero. This mask is defined for diamagnetic structures. A mask for paramagnetic structures can similarly be defined as:

$$mask_{para}(x,y) = \begin{cases} \exp\left\{-\alpha(|\phi_h(x,y)| - \sigma\frac{\pi}{100})^\beta\right\} & |\phi_h(x,y)| < \sigma\frac{\pi}{100} \\ 1 & |\phi_h(x,y)| \ge \sigma\frac{\pi}{100} \end{cases}$$

The magnitude image $|S_{swip}|$ is multiplied with the respective phase mask to produce the desired susceptibility-weighted MR image. Fig. 2g shows the magnitude image with diamagnetic susceptibility weighting while Fig. 2h shows the magnitude image with paramagnetic susceptibility weighting. The presence of the stones in the Agar-Agar medium is emphasized in the susceptibility weighted images. Moreover, it can be seen that the presence of air bubbles (indicated by arrows) that are not recognizable in the magnitude image of Fig. 2a become visible by the susceptibility weighting in Fig. 2g and 2h.

It can thus be concluded that the method of the invention is able to provide two different contrasts from the same raw MR signal data. By the MRE processing, the shear stiffness of the tissue of interest can be calculated, and additionally using the above described post-processing of the acquired MRE data according to the invention significantly improves the contrast of the MR magnitude images by highlighting susceptibility variations.

It should be noted that typically four (or more) different phase offset MR images are acquired in known MRE techniques. However, the background phase information is expected to be the same in all these images. This implies that the susceptibility contrast can be derived from the full set of phase offset MR images, and an optimal image combination method could improve the susceptibility contrast even further. One example of the combination of individual phase offset MR images is a simple arithmetic averaging.

One of the widely used applications of SWI imaging is in brain imaging. MRE imaging is also currently subject of investigations for the imaging of the brain. Fig. 3 illustrates the application of the method of the invention for brain imaging. The image contents of Figs. 3a-3h correspond to those of Figs. 2a-2h. The arrows in Figs. 3g and 3h indicate where the contrast is improved by the susceptibility contrast introduced by the method of the invention. The contrast of the diamagnetic choroid plexus is clearly seen in Fig. 3g (diamagnetic mask) while the contrast of the internal cerebral veins is enhanced in Fig. 3h (paramagnetic mask).

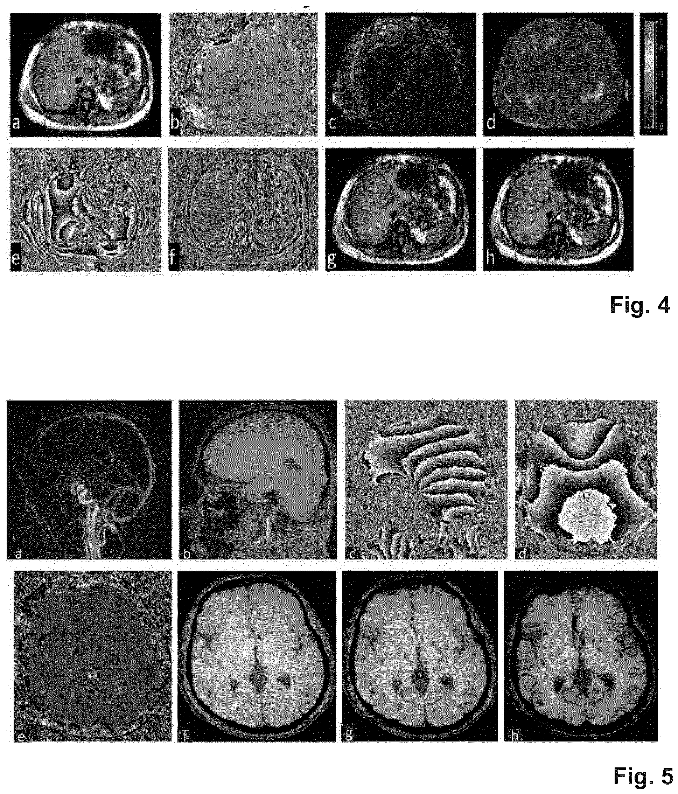

Today, MRE is clinically applied to a large extent for the assessment of liver fibrosis. The technique is used widely and is gaining clinical acceptance. Fig. 4 shows the application of the method of the invention to liver MRE data. Again, the image contents of Figs. 4a-4h correspond to those of Figs. 2a-2h. An enhancement of the contrast between the liver vasculature and the parenchyma can clearly be seen in the dia- and paramagnetic mask weighted magnitude images of Figs. 4g and 4h respectively.

Phase contrast angiography (PCA) is another common MR imaging technique that can be combined with the method of the invention. The MR signal data of the PCA acquisition inherently contains the background phase information which is used according to the invention for extracting susceptibility information. Hence, a susceptibility weighting can be derived while simultaneously a default PCA image is reconstructed. In PCA, velocity encoding can be done for flowing blood in one, two or three orthogonal directions which allows identifying vessels or a blockage within them. For encoding velocity in n directions, at least n+1 datasets need to be acquired. Taking the case of velocity encoding in three directions, x, y and z, four different MR image data sets are acquired with the following encodings:

$$S_1 = S_0 \cdot e^{-i\frac{\gamma G\tau^2\left(-v_x-v_y-v_z\right)}{2}+\theta_b}$$

$$S_2 = S_0 \cdot e^{-i\frac{\gamma G\tau^2\left(-v_x+v_y+v_z\right)}{2}+\theta_b}$$

$$S_3 = S_0 \cdot e^{-i\frac{\gamma G\tau^2\left(v_x-v_y+v_z\right)}{2}+\theta_b}$$

$$S_4 = S_0 \cdot e^{-i\frac{\gamma G\tau^2\left(v_x+v_y-v_z\right)}{2}+\theta_b}$$

Where $v_x$, $v_y$, $v_z$ are the velocities of blood along the x-, y- and z-directions respectively, G is the amplitude of the bipolar gradient used for velocity encoding, $\tau$ is the duration of one lobe of the bipolar velocity encoding gradient, $\gamma$ is the gyromagnetic ratio in units of Hertz/Tesla and $\theta_b$ is again the background phase.

The blood velocity information can be extracted from the phase of the PCA image data for x-directional velocity as follows:

$$S_{pca,x} = \frac{S_3}{S_2} \cdot \frac{S_4}{S_1}$$

$$\angle S_{pca,x} = 2\gamma G v_x \tau^2$$

Similarly,

$$S_{pca,y} = \frac{S_4}{S_3} \cdot \frac{S_2}{S_1}, \quad \angle S_{pca,y} = 2\gamma G v_y \tau^2$$

and

$$S_{pca,z} = \frac{S_3}{S_4} \cdot \frac{S_2}{S_1}, \quad \angle S_{pca,z} = 2\gamma G v_z \tau^2.$$

The following operation extracts the background phase information from the PCA image data:

$$|S_{swi}| = \frac{|S_1|+|S_2|+|S_3|+|S_4|}{4}$$

$$\angle S_{pca,SWIp} = \angle\left(\frac{S_1 \cdot S_2 \cdot S_3 \cdot S_4}{c}\right) = 4 \cdot \theta_b \qquad \text{(Eq. A)}$$

or

$$\angle S_{pca,SWIp} = \angle(S_1 + S_2 + S_3 + S_4) = \theta_b \qquad (\text{Eq. B})$$

c is a normalizing factor which is typically set to 1.

Using $|S_{swi}|$ and $\angle S_{pca,SWIp}$, the desired susceptibility-weighted MR image can be generated using the steps laid out above to produce phase masks for highlighting diamagnetic and paramagnetic structures respectively.

A unique aspect of using PCA data for generating susceptibility weighting is that the phase of the MR signals from vessel regions is fully velocity compensated in $\angle S_{pca,SWIp}$. This implies that the detected phase is solely determined by the susceptibility properties and not influenced by flow. This is not the case in conventional multi-echo SWI sequences, unless explicit flow compensation gradients are used. The invention achieves flow compensation indirectly through the velocity encoding that is inherent in the PCA acquisition, i.e. without applying velocity compensation gradients along phase or slice directions.

Another advantage of using three-dimensional PCA data for SWI generation is that four different MR signal data sets acquired at the same echo-time are combined. This essentially improves the effective sensitivity of the determination of $\theta_b$, whether obtained through Eq. A or Eq. B above, thereby providing an effective echo time that is at least two times longer than the actual echo time used in the single PCA data acquisition. For example, if an echo time of 7 ms is used in the PCA acquisition, the effective echo time for the susceptibility weighting can be at least 14 ms. Comparing this with the 20 ms echo time that is typically used in the conventional SWI technique it is realized that sensitivity is not significantly reduced by using the PCA acquisition to derive the susceptibility weighting.

Fig. 5 shows example images to illustrate the application of the method of the invention in combination with a PCA acquisition. Fig. 5a is a conventionally reconstructed 3D PCA image displayed in a maximum intensity projection. Fig. 5b shows the average magnitude image $|S_{swi}|$ reconstructed from the same PCA data. The image of the corresponding background phase image

$\angle S_{pca,SWIp}$ is shown in Fig. 5c. Fig. 5d shows the same image reformatted to axial orientation. The unwrapped and filtered phase image corresponding to the image of Fig. 5d is shown in Fig. 5e. Fig. 5f shows the un-processed reformatted axial magnitude image (single slice). Fig. 5g shows the susceptibility weighted image wherein a phase mask derived from the phase image of Fig. 5e is applied to the image data of Fig. 5f. A minimum intensity projection over eight slices of the susceptibility weighted image data set is shown in Fig. 5h. An enhancement of the contrast between the brain tissue and the susceptibility causing structures like veins and grey matter nuclei can clearly be seen (indicated by arrows).

**Claims**

1. Method of MR imaging of an object (10) placed in an examination volume of a MR apparatus (1), the method comprising the steps of:

   - generation of MR signals by subjecting the object (10) to an imaging sequence comprising motion- or flow-encoding switched magnetic field gradients;
   - phase-sensitive acquisition of the MR signals; and
   - reconstruction of at least one MR image from the acquired MR signals, wherein a motion- or flow-contrast is derived from the motion- or flow-induced phase information and wherein a susceptibility-weighting is derived from the motion- or flow independent phase information comprised in the acquired MR signals.

2. Method of claim 1, wherein the imaging sequence comprises pairs of motion- or flow-encoding magnetic field gradients having opposed/varying polarities.

3. Method of claim 1 or 2, wherein the MR signals are generated and acquired in accordance with a phase contrast angiography technique.

4. Method of claim 1 or 2, wherein the MR signals are generated and acquired in accordance with an MR elastography technique.

5. Method of any one of claims 1-4, wherein the MR image is weighted using a diamagnetic or a paramagnetic phase mask derived from the motion- or flow-independent phase information.

6. Method of any one of claims 1-5, wherein at least two MR images are reconstructed from the acquired MR signals, whereof a first MR image is a phase-contrast MR image, most notably a phase contrast angiogram or a magnetic resonance elastography phase image, and a second MR image is a susceptibility weighted image.

7. MR apparatus including at least one main magnet coil (2) for generating a uniform, static magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17), wherein the MR apparatus (1) is arranged to perform the following steps:

- generation of MR signals by subjecting the object (10) to an imaging sequence comprising motion- or flow-encoding switched magnetic field gradients;
- phase-sensitive acquisition of the MR signals; and
- reconstruction of at least one MR image from the acquired MR signals, wherein a motion- or flow-contrast is derived from the motion- or flow-induced phase information and wherein a susceptibility-weighting is derived from the motion- or flow independent phase information comprised in the acquired MR signals.

8. Computer program to be run on an MR apparatus, which computer program comprises instructions for:

- generation an imaging sequence comprising motion- or flow-encoding switched magnetic field gradients;
- phase-sensitive acquisition of MR signals; and
- reconstruction of at least one MR image from the acquired MR signals, wherein a motion- or flow-contrast is derived from the motion- or flow-induced phase information and wherein a susceptibility-weighting is derived from the motion- or flow-independent phase information comprised in the acquired MR signals.

Fig. 1

Fig. 2

Fig. 3

Fig. 4

Fig. 5

Europäisches
Patentamt

European
Patent Office

Office européen
des brevets

# EUROPEAN SEARCH REPORT

Application Number

EP 19 17 0364

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2008/119721 A1 (KIMURA TOKUNORI [JP] ET AL) 22 May 2008 (2008-05-22) * paragraph [0169] - paragraph [0183]; figures 12, 18, 19 * ----- | 1-8 | INV. G01R33/44 G01R33/563 |
| A | RO Y M ET AL: "Phase-dependent-image enhancement in magnetic resonance imaging", SPIE CONFERENCE ON PHYSICS OF MEDICAL IMAGING, vol. 3336, 1 February 1998 (1998-02-01), pages 761-770, XP002539973, DOI: 10.1117/12.317083 ISBN: 978-1-62841-730-2 * the whole document * ----- | 1-8 | |

TECHNICAL FIELDS
SEARCHED      (IPC)

G01R

The present search report has been drawn up for all claims

| Place of search | Date of completion of the search | Examiner |
|---|---|---|
| Munich | 15 October 2019 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 17 0364

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2019

| Patent document cited in search report | Publication date | Patent family member(s) | Publication date |
|---|---|---|---|
| US 2008119721 A1 | 22-05-2008 | US 2008119721 A1<br>US 2011071384 A1 | 22-05-2008<br>24-03-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **C. L. DUMOULIN ; S. P. SOUZA ; M. F. WALKER ; W. WAGLE.** Three-dimensional phase contrast angiography. *Magn. Reson. Med.,* January 1989, vol. 9 (1), 139-149
- **R. MUTHUPILLAI ; D. J. LOMAS ; P. J. ROSSMAN ; J. F. GREENLEAF ; A. MANDUCA ; R. L. EHMAN.** Magnetic resonance elastography by direct visualization of propagating acoustic strain waves. *Science,* September 1995, vol. 269 (5232), 1854-1857
- **E. M. HAACKE ; Y. XU ; Y.-C. N. CHENG ; J. R. REICHENBACH.** Susceptibility weighted imaging (SWI). *Magn. Reson. Med. Off. J. Int. Soc. Magn. Reson. Med.,* 2004, vol. 52 (3), 612-618
- **N. J. PELC ; M. A. BERNSTEIN ; A. SHIMAKAWA ; G. H. GLOVER.** Encoding strategies for three-direction phase-contrast MR imaging of flow. *J. Magn. Reson. Imaging,* 1991, vol. 1 (4), 405-413